# EUROPÄISCHE PATENTSCHRIFT

(11) **EP 1 994 554 B1**
(45) Veröffentlichungstag und Bekanntmachung des Hinweises auf die Patenterteilung: **29.07.2015**
(21) Anmeldenummer: 07712404.8
(22) Anmeldetag: 01.03.2007
(51) Int. Cl.: H01L 21/78, H01L 21/67, H01L 21/683

(54) **VERFAHREN ZUM BEARBEITEN INSBESONDERE DÜNNEN DER RÜCKSEITE EINES WAFERS, WAFER-TRÄGER-ANORDNUNG HIERFÜR UND VERFAHREN ZUR HERSTELLUNG EINER SOLCHEN WAFER-TRÄGER-ANORDNUNG**
METHOD FOR PROCESSING, IN PARTICULAR, THIN REAR SIDES OF A WAFER, WAFER-CARRIER ARRANGEMENT AND METHOD FOR PRODUCING SAID TYPE OF WAFER-CARRIER ARRANGEMENT
PROCÉDÉ D'USINAGE NOTAMMENT DE LA MINCE FACE ARRIÈRE D'UNE PLAQUETTE, DISPOSITIF SUPPORT DE TRANCHE UTILISÉ ET PROCÉDÉ DE PRODUCTION D'UN SYSTÈME SUPPORT DE PLAQUETTE

(30) Priorität: 01.03.2006 DE 102006009394; 01.03.2006 DE 102006009353; 16.10.2006 DE 102006048800; 16.10.2006 DE 102006048799
(43) Veröffentlichungstag der Anmeldung: 26.11.2008
(73) Patentinhaber: Thin Materials GmbH, 82223 Eichenau (DE)
(72) Erfinder: JAKOB, Andreas, 82319 Starnberg (DE)
(74) Vertreter: Eisenführ Speiser
(86) Internationale Anmeldenummer: PCT/EP2007/051952
(87) Internationale Veröffentlichungsnummer: WO 2007/099146

(56) Entgegenhaltungen:
- EP-A- 1 592 058
- WO-A-2004/007628
- DE-A1- 10 353 530
- US-A1- 2001 024 118
- US-A1- 2004 188 861
- US-B1- 6 202 299

## Beschreibung

Die vorliegende Erfindung betrifft eine Wafer-Träger-Anordnung, umfassend einen Wafer, ein Trägerschichtsystem und eine Trennschicht, die zwischen dem Trägerschichtsystem und dem Wafer angeordnet ist. Die Erfindung betrifft ferner die Verwendung einer solchen Wafer-Träger-Anordnung bei der Bearbeitung der Rückseite eines Wafers, bevorzugt beim Dünnen und/oder Vereinzeln des Wafers, sowie ein Verfahren zum Herstellen einer solchen Wafer-Träger-Anordnung sowie ein Verfahren zum Bearbeiten der Rückseite eines Wafers, insbesondere zum Dünnen der Rückseite eines Wafers und/oder zum Vereinzeln eines Wafers.

Derzeit besteht hoher Bedarf an möglichst dünnen elektronischen Bauelementen und Schaltungen. Bei der Herstellung von solchen elektronischen Bauelementen und Schaltungen (Dioden, Transistoren, IC's, Sensoren etc.) werden auf Wafern (gegebenenfalls dotierten Scheiben aus Silizium, Galliumarsenid etc.) mittels verschiedener Technologieren Strukturen und Schichten zum Erzeugen der gewünschten elektronischen Funktionen aufgebracht. Gegenwärtig werden diese Wafer nach Abschluss der hierzu notwendigen Fertigungsschritte auf der Vorderseite (das ist die aktive Seite bzw. die Seite, auf der sich die aufgebrachten Strukturen befinden) mit einer Schutzfolie oder einer sonstigen Schutzschicht versehen. Diese Folie bzw. Schicht hat die Aufgabe, die Wafervorderseite und insbesondere die darauf aufgebrachten elektrischen und mechanischen Strukturen während des anschließend folgenden Dünnens und/oder anderer Bearbeitung der Rückseite des Wafers zu schützen. Das Dünnen erfolgt durch Techniken wie Grinden, Läppen, Schleifen, Ätzen oder Vergleichbares der Rückseite des Wafers.

Ziel dieses Vorgehens ist es, die ursprüngliche Dicke des Wafers zu reduzieren. Dabei wird das Ausmaß der Reduktion entscheidend von den zu erwartenden mechanischen und thermischen Belastungen während des Abdünnens und/oder der weiteren nachfolgenden Prozessschritte bestimmt: Da der Wafer, wenn er gedünnt wird, schon eine Vielzahl von Prozessschritten durchlaufen hat, stellt er bereits einen hohen wirtschaftlichen Wert dar. Daher muss das Risiko des Zerbrechens des Wafers möglichst gering gehalten werden. Dementsprechend ist eine Abdünnung in dem Maße, wie sie eigentlich gewünscht wäre, oft nicht möglich, da anderenfalls zu große Verluste durch Brechen der Wafer auftreten.

Gemäß dem Stand der Technik wird nach dem Abdünnen zur Verbesserung der Brucheigenschaften des Wafers häufig eine chemische Behandlung der Waferrückseite vorgenommen. Nach eventuellen Reinigungsschritten wird die Schutzfolie von der Waferoberseite abgezogen oder anderweitig entfernt. Es können sich nun weitere Fertigungsschritte und/oder Maßnahmen zur Verbesserung der Eigenschaften des Wafers sowie Untersuchungen wie z. B. zur Qualitätskontrolle anschließen. Vielfach wird die Rückseite des gedünnten Wafers mit einer metallischen Schicht überzogen. Dieses Beschichtungsverfahren erfolgt meist mittels Sputtern oder ähnlichen Abscheideverfahren im Vakuum und bedingt vielfach thermische Belastung. Danach wird der Wafer mit der Rückseite nach unten (aktive Seite nach oben) auf eine Sägefolie, eine Expansionsfolie bzw. einen Rahmen aufgelegt. Anschließend erfolgt das Vereinzeln des Wafers, d. h. der Wafer wird in vereinzelte Bauteile (Mikroplättchen, Dies) aufgetrennt. Dieses Vereinzeln erfolgt häufig mittels Rotationstrennscheiben oder anderen mechanischen Sägevorrichtungen. Es kommen aber auch Lasertrennverfahren zur Anwendung. Alternativ werden die Wafer beim Vereinzeln auch gebrochen, wobei zum Teil unterstützende Verfahren wie Ritzen zur Anwendung kommen.

Aus den genannten Gründen ist es mit den herkömmlichen Verfahren sehr schwierig, sehr dünne Wafer zu behandeln bzw. herzustellen. Diese Schwierigkeiten ergeben sich unter anderem daraus, dass der Wafer beim und nach dem Abdünnen mechanischen Belastungen ausgesetzt werden muss. Diese Belastungen treten unter anderem auf:
- während des Dünnens des Wafers, wobei der Wafer wenn er sehr stark abgedünnt wird, dazu neigt, sich zu wellen,
- während des Abziehens der Schutzfolie bzw. der Schutzschicht, die während des Abdünnens die Wafervorderseite schützt,
- während des Auflegens des Wafers auf die Sägefolie und
- während des Transportes zwischen den einzelnen Fertigungsschritten, insbesondere aber bei der Beschichtung der Rückseite, wobei wenigstens thermische Belastungen auch dann auftreten, wenn die Rückseitenbeschichtung bereits nach dem Vereinzeln des Wafers stattfindet.

Alternativ zu den genannten Verfahren werden heute auch Verfahren angewendet, bei denen der Wafer auf der Vorderseite bereits vor dem Dünnungsprozess mittels Schleifens von Ritzstrukturen, Ritzens, chemischen Ätzens, Plasmaätzens von Gräben und/oder Strukturen so strukturiert wird, dass diese Strukturen während des sich anschließenden Dünnungsprozesses mittels mechanischer und/oder chemischer Verfahren von der Rückseite so erreicht werden, dass der Wafer vereinzelt wird.

Eine Alternative bei den vorgenannten Techniken beim Dünnen und weiteren Bearbeiten des Wafers wird in der Offenlegungsschrift DE 103 53 530 und der WO 2004/051708 offenbart: In diesen Schriften wird vorgeschlagen, für das Dünnen und nachfolgende Bearbeiten des Wafers eine Trennschicht und eine Trägerschicht einzusetzen, wobei die Trennschicht eine plasmapolymere Schicht ist, die an der Trägerschicht fester haftet als am Wafer. Durch die aufgrund des Plasmapolymerisationsverfahrens durch den Fachmann einstellbaren Adhäsions- bzw. Dehäsionseigenschaften der plasmapolymeren Schicht, ist es möglich, die Schicht so auszugestalten, dass diese eine größere Haftfestigkeit mit der Trägerschicht als mit dem Wafer aufweist. Dabei kann die Haftfestigkeit zum Wafer so eingestellt werden, dass auch ein sehr dünner Wafer von der Trennschicht (und der Trägerschicht) gelöst werden kann ohne dass zu hohe mechanische Belastungen auftreten.

Nachteilig an den in den genannten Dokumenten offenbarten Verfahren ist, dass die dort vorgeschlagene Trägerschicht nicht optimal angepasst ist: Insbesondere bei dreidimensionalstrukturierten Waferoberflächen (wie z. B. mit Bumps versehene Wafer oder Wafer mit Hinterschneidung an ihrer Oberfläche) ist die vorgeschlagene Trägerschicht (z. B. Polyimid oder Polyamid) zu hart: Da die plasmapolymere Trennschicht die Oberflächenstrukturen des Wafers im Wesentlichen mit einer gleichbleibend dicken Schicht belegt, sollten Zwischenräume wie Hinterschneidungen oder Zwischenräume zwischen den Bums von dem Material für die Trägerschicht ausgefüllt werden. Ist dies der Fall, kommt es aufgrund der Härte der Trägerschicht allerdings dazu, dass die Trägerschicht nicht zerstörungsfrei vom Wafer wieder ablösbar ist. Füllt die Trägerschicht die Oberflächenstrukturen nicht aus, verbleiben Hohlräume, die die Haftung zwischen Träger- und Trennschicht negativ beeinflussen und zu unerwünschten Einschlüssen führen können. Hinzu tritt, dass aufgrund unterschiedlicher Wärmeausdehnungskoeffizienten von Trägerschicht und Wafer zusätzlicher mechanischer Stress für den Wafer erzeugt wird.

Daher war es Aufgabe der vorliegenden Erfindung, ein verbessertes Schichtsystem, insbesondere hinsichtlich der Trägerschichtgestaltung anzugeben.

Erfindungsgemäß wird diese Aufgabe gelöst durch eine Wafer-Träger-Anordnung wie in Anspruch 1 definiert, umfassend
- einen Wafer,
- ein Trägerschichtsystem und
- eine Trennschicht, die zwischen dem Trägerschichtsystem und dem Wafer angeordnet ist,
wobei das Trägerschichtsystem
(i) eine Trägerschicht und
(ii) eine Schicht aus einem ausgehärteten, teilausgehärteten oder aushärtbaren Elastomermaterial trennschichtseitig umfasst oder aus diesen beiden Schichten besteht und
   wobei die Trennschicht
(iii) eine plasmapolymere Schicht ist und
(iv) die Haftfestigkeit zwischen dem Trägerschichtsystem und der Trennschicht nach Aushärten des Elastomermaterials größer ist als die Haftfestigkeit zwischen dem Wafer und der Trennschicht.

Elastomermaterial ist in diesem Text neben den bereits auspolymerisierten Elastomeren auch deren niedermolekulare Vorstufen (bis hin zu den Monomeren). Es kann sich um niedermolekulare Flüssigkeiten oder pastenähnliche Materialien handeln, die noch nicht oder nur teilweise vernetzt sind.

Dementsprechend sind aushärtbare Elastomermaterialien im Rahmen dieses Textes handelsübliche Vorstufen für polymere Elastomere. Teilausgehärtetes Elastomermaterial ist im Zusammenhang mit diesem Text aushärtbares Elastomermaterial, das bereits einer Polymerisation/Vernetzung unterworfen wurde, wobei aber die Polymerisation/Vernetzung noch nicht abgeschlossen ist und/oder eine weitere Polymerisation/Vernetzung gegebenenfalls über einen alternativen chemischen oder physikalischen Mechanismus erfolgen kann. Ausgehärtetes Elastomermaterial sind im Rahmen dieses Textes Elastomere, deren Polymerisation/Vernetzung im Wesentlichen abgeschlossen ist. Hierbei ist anzumerken, dass mit dem Abschließen der Polymerisation/Vernetzung gemeint ist, dass das Elastomer im klassischen Sinne vorliegt.

Eine "plasmapolymere Schicht" ist im Rahmen dieses Textes eine Schicht, welche mittels Plasmapolymerisation herstellbar ist. Plasmapolymerisation ist ein Verfahren, bei dem sich gasförmige Precursoren (oft auch Monomere genannt), angeregt durch ein Plasma, auf einem frei wählbaren Substrat als hochvernetzte Schicht niederschlagen. Voraussetzung für eine Plasmapolymerisation ist das Vorhandensein von kettenbildenden Atomen wie Kohlenstoff oder Silicium im Arbeitsgas. Durch die Anregung werden die Moleküle der gasförmigen Substanz (Precursoren), durch den Beschuss mit Elektronen und/oder energiereichen Ionen fragmentiert. Dabei entstehen hochangeregte radikalische oder ionische Molekülfragmente, die miteinander im Gasraum reagieren und auf der zu beschichtenden Oberfläche abgeschieden werden. Auf diese abgeschiedene Schicht wirkt die elektrische Entladung des Plasmas und dessen intensiver Ionen- und Elektronenbeschuss fortwährend ein, so dass in der abgeschiedenen Schicht weitere Reaktionen ausgelöst und eine hochgradige Verknüpfung der abgeschiedenen Moleküle erzielt werden kann.

Im Rahmen des vorliegenden Textes umfasst der Begriff "plasmapolymere Schicht" auch Schichten, die mittels plasmaunterstützter CVD (PE-CVD) hergestellt werden können. Hierbei wird zur Reaktionsführung das Substrat zusätzlich erwärmt. So lassen sich beispielsweise aus Silan und Sauerstoff SiO₂-Beschichtungen herstellen. Ferner sei ausdrücklich erwähnt, dass auch Atmosphärendruckplasmaverfahren zur Herstellung erfindungsgemäß einzusetzender plasmapolymerer Schichten verwendet werden können, wenngleich Niederdruck-Plasmapolymerisationsverfahren derzeit bevorzugt sind. Im Rahmen des vorliegenden Textes werden Substanzen, die zur Schichtbildung über eine Plasmapolymerisation als Gas bzw. Dampf einem Plasma zugeführt werden, als "Monomere" (gasförmige Precursoren) bezeichnet. Als "flüssige Precursoren" werden Flüssigkeiten bezeichnet, welche beispielsweise durch die Einwirkung eines Plasmas vernetzt werden können (beispielsweise durch hochangeregte Teilchen, Elektronen oder UV-Strahlung), ohne vorher zu verdampfen.

Plasmapolymere Schichten sind in ihrer mikroskopischen Zusammensetzung eindeutig von polymeren Schichten zu unterscheiden. Während bei Polymeren der Verknüpfungsprozess der Monomere in vorhersagbarer Weise geschieht, werden bei der Plasmapolymerisation die eingesetzten Monomere durch Kontakt mit dem Plasma stark verändert (bis zur vollständigen Zerstörung) und in Form von reaktiven Spezies abgeschieden, so dass sich eine hochvernetzte Schicht ergibt, ohne regelmäßig repetetive Bereiche. Dementsprechend unterscheidet sich die Plasmapolymerisation im Sinne dieses Textes von der plasmainduzierten Polymerisation. Dies gilt auch für die sogenannte "strukturerhaltende Plasmapolymerisation", da selbst bei "milden" Plasmabedingungen unvorhersagbare Molekülbrüche auftreten.

In der oben erwähnten WO 2004/051708 A2 sind für die vorliegende Erfindung geeignete plasmapolymere Schichten offenbart. Auf dem Wege der Verweisung wird die genannte Offenlegungsschrift hier in diesem Text inkorporiert. Dies gilt insbesondere für die Angaben aus der WO 2004/051708 A2 zur Herstellung der plasmapolymeren Trennschicht und zu der Trennschicht selbst.

Auch aus der Patentschrift DE 100 34 737 C2 sind ebenfalls für die vorliegende Erfindung einsetzbare plasmapolymere Trennschichten offenbart. Hier ist allerdings zu berücksichtigen, dass die stärker dehäsiv wirkende Oberfläche der dort offenbarten plasmapolymeren Trennschicht zum Wafer ausgerichtet sein muss und somit bei Abscheidung der plasmapolymeren Trennschicht auf den Wafer die Reaktionsführung für den Plasmaprozess entsprechend umgekehrt zu in der DE 100 34 737 C2 offenbarten Weise zu erfolgen hat. Mit dieser Maßgabe ist auch der Offenbarungsgehalt, insbesondere hinsichtlich der Abscheidungsprozesse und der plasmapolymeren Trennschicht selbst aus der DE 100 34 737 C2 hiermit auf dem Wege der Verweisung Bestandteil des vorliegenden Anmeldungstextes.

Die Haftfestigkeit zwischen den jeweiligen Schichten kann der Fachmann nach der DIN 971-1: 1996-09 bestimmen und sie wird definiert als "Gesamtheit der Bindekräfte zwischen einer Beschichtung und ihrem Untergrund".

Der Vorteil der erfindungsgemäßen Wafer-Träger-Anordnung besteht darin, dass sich aufgrund der Eigenschaften des Elastomermaterials (Flexibilität, Dehnbarkeit) eine ideale Verbindung zwischen der Trägerschicht und der sich gegebenenfalls auf dem Wafer befindenden Trennschicht herstellen lässt. Insbesondere kann die Haftfestigkeit zwischen der plasmapolymeren Schicht und der Schicht aus Elastomermaterial so eingestellt werden, dass bei einer Trennung zwischen des Trägerschichtsystems aus Trägerschicht und Schicht aus Elastomermaterial und dem Wafer die Trennschicht an der Elastomerschicht haften bleibt. Gleichzeitig ist auch bei vorhandenen dreidimensionalen Oberflächenstrukturen wie Bumps und Hinterschneidungen auf dem Wafer eine Trennung vom Wafer gut möglich.

Die Elastomerschicht hat des weiteren den Vorteil, dass sie in der Lage ist, in einem gewissen Rahmen Spannungen auszugleichen, die aufgrund unterschiedlicher Wärmeausdehnungskoeffizienten für die Längenausdehnung zwischen der jeweils eingesetzten Trägerschicht und dem Wafer auftreten. Ein weiterer wesentlicher Vorteil der Elastomerschicht besteht darin, dass sie bei ausreichender Stärke verhindert, dass sich Erhebungen auf der Wafervorderseite wie z. B. Bums aufgrund des mechanischen Stresses, der beim Dünnen des Wafers auftritt, auf den Wafer durchdrücken, so dass Unebenheiten entstehen und im Extremfall der Wafer zerstört werden kann.

Wichtig für die vorliegende Erfindung ist die Auswahl des Elastomermaterials und die Anpassung der plasmapolymeren Trennschicht sowohl an dieses Material als auch an die jeweils vorliegende Waferoberfläche. Die plasmapolymere Trennschicht passt der Fachmann durch geeignete Verfahrensführung beim plasmapolymeren Abscheidungsprozess (oder auch PECVD-Verfahren) an. Die plasmapolymere Trennschicht vermittelt dabei die notwendigen Hafteigenschaften, so dass die Wafer-Träger-Anordnung bei aufgebrachtem Schichtsystem gut gehandhabt werden kann. Dies gilt insbesondere auch für das Handling während des Abdünnens. Andererseits muss das Trägerschichtsystem sich auf geeignete Weise vom Wafer lösen lassen. Die erwähnte Ausgestaltung der plasmapolymeren Trennschicht hinsichtlich ihrer Haftfestigkeit führt dazu, dass zwischen der Waferoberfläche (die ebenfalls auch eine weitere Schicht wie z. B. eine Passivierungsschicht umfassen kann) und der Trennschicht eine Sollbruchstelle eingeführt wird. Dabei sind für die Hafteigenschaften dieser Sollbruchstelle die Handhabbarkeit vor der Trennung (bzw. die hier auftretenden Belastungen) und den Belastungstoleranzen des Wafers nach dem Dünnen während der Trennung entscheidend.

Eine wichtige Rolle spielt selbstverständlich auch die Schicht aus Elastomermaterial: Die Härte des Elastomermaterials muss so sein, dass das Material weich genug ist, auch eine strukturierte Waferoberfläche bevorzugt hohlraumfrei zu umschließen (wobei auf der Struktur der Oberfläche die strukturnachformende Trennschicht schon vorhanden sein kann). Außerdem muss das Silikonmaterial hart genug sein bzw. in einen ausreichend harten Zustand versetzbar sein, nach dem Aufbringen des Trägerschichtsystemes auf die Waferoberfläche (mittelbar, da die plasmapolymere Trennschicht ja zwischen Waferoberfläche und Trennschichtsystem angeordnet ist) die Handhabbarkeit der Wafer-Träger-Anordnung zu gewährleisten. Insbesondere muss die Elastomerschicht in sich fest genug sein, dass eine Trennung zwischen Wafer und plasmapolymerer Trennschicht erfolgt und nicht etwa die Elastomerschicht in sich reißt.

Dem Fachmann ist selbstverständlich leicht nachvollziehbar, dass auch die Haftfestigkeit der beiden das Trägerschichtsystem bildenden Schichten (Trägerschicht und Schicht aus einem ausgehärteten, teilausgehärteten oder aushärtbarem Elastomermaterial) zueinander größer sein muss, als die Haftfestigkeit zwischen der Trennschicht und dem Wafer.

Beim Aufbau der erfindungsgemäßen Wafer-Träger-Anordnung muss das Elastomermaterial wie bereits erwähnt ausreichend weich sein, um die Topographie der Waferoberfläche vollständig zu umschließen. Dies kann beispielsweise dadurch erzielt werden, dass aushärtbares Elastomermaterial flüssig in Form von geeigneten spinn- oder spraycoating oder anderen Technologien zum Aufbringen flüssiger Materialien auf einen mit einer plasmapolymeren Trennschicht beschichteten Wafer aufgebracht wird. Anschließend muss das flüssige aushärtbare Elastomermaterial ausgehärtet werden, um seine Funktion erfüllen zu können. Alternativ ist es auch möglich, das aushärtbare oder teilausgehärtete Elastomermaterial auf eine Trägerschicht aufzubringen und es gegebenenfalls so weit teilauszuhärten, so dass eine gelartige Konsistenz entsteht. Selbstverständlich stehen dem Fachmann für die Verbindung der Trägerschicht mit der Schicht aus Elastomermaterial eine Vielzahl von Möglichkeiten zur Verfügung, die von z. B. Kleben über Vulkanisieren bis zum Verpressen reichen. Hier wählt der Fachmann abhängig von den jeweils eingesetzten Materialien die geeignete Methode.

Sobald das Trägerschichtsystem hergestellt ist, kann es mit dem Wafer, auf den die plasmapolymere Trennschicht abgeschieden wurde, verbunden werden. Dies kann beispielsweise durch Verpressen geschehen, wobei aber auch andere physikalische und/oder chemische adhäsionserzeugende Techniken eingesetzt werden können. Auch hier wählt der Fachmann in Abhängigkeit von dem tatsächlich eingesetzten Material sowohl für die Trennschicht als auch für die Schicht aus Elastomermaterial das entsprechende Verfahren. Außerdem berücksichtigt der Fachmann dabei den Zustand, in dem das Elastomermaterial sich befinden wird, wenn die Trennung der Trennschicht vom Wafer erfolgen soll. Dies ist insbesondere dann von Bedeutung, wenn das Elastomermaterial noch nicht vollständig ausgehärtet ist - was eine bevorzugte Variante ist - wenn es mit der (plasmapolymerbeschichteten) Waferoberfläche in Verbindung gebracht wird. Für den Fachmann ist selbstverständlich nachvollziehbar, dass bei einer plasmapolymeren Trennschicht, die eine ausreichende Elastizität und Dehnbarkeit besitzt, die plasmapolymere Trennschicht auch auf die Schicht aus aushärtbarem Elastomermaterial abgeschieden werden kann. In diesem Falle würde erst in einem nachfolgenden Schritt das Trägerschichtsystem, das auf der von der Trägerschicht abgewandten Seite die plasmapolymere Schicht umfasst, mit dem Wafer durch geeignete adhäsionserzeugende Verfahren in Verbindung gebracht. Auch hier ist wieder entscheidend, dass eine gute Umschließung der gegebenenfalls strukturierten Waferoberfläche erfolgt. Insbesondere wird der Fachmann darauf achten, dass beim Herstellen der erfindungsgemäßen Wafer-Träger-Anordnung eine ganzflächige Verteilung der Schicht aus Elastomermaterial hinsichtlich der Waferoberfläche erfolgt und das Schichtsystem möglichst, bevorzugt völlig, ohne Einschlüsse von Luft oder Hohlräumen hergestellt wird. Dies kann in einer bevorzugten Variante der Erfindung insbesondere dadurch erreicht werden, dass das aushärtbare Elastomermaterial bzw. das teilausgehärtete Elastomermaterial der Schicht aus Elastomermaterial ausreichend "flüssig" ist, dass es die Strukturen in der Waferoberfläche (aufgrund der plasmapolymeren Trennschicht *mittelbar*) umschließt. Nachfolgend kann dann das Aushärten erfolgen. Selbstverständlich kann das Laminieren auch unter Vakuumbedingungen erfolgen.

Das Aushärten des aushärtbaren Elastomermaterials oder des teilausgehärteten Elastomermaterials erfolgt durch eine vom Fachmann zu wählende an das Material angepassten Weise beispielsweise durch Zuführen oder Entziehen von Energie in Form von Wärme oder durch geeignete chemische Reaktionen wie beispielsweise Polymerisation und/oder Vulkanisation.

Der Fachmann versteht selbstverständlich, dass die Schicht aus Elastomermaterial nicht vollständig aus diesem Material bestehen muss und noch geeignete Zusätze umfassen kann. Dabei werden aber die mechanischen Eigenschaften im Wesentlichen durch das Elastomermaterial geprägt: Die Schicht ist selbstverständlich besonders bevorzugt nach dem Aushärten nach wie vor eine elastomere Schicht.

Für den Fachmann ist leicht nachvollziehbar, dass die erfindungsgemäße Wafer-Träger-Anordnung auch weitere Schichten umfassen kann wie z. B. eine Klebstoffschicht zwischen der Trägerschicht und der Schicht aus Elastomermaterial. Letztendlich ist entscheidend, dass die genannten Schichten jeweils ihre Funktion erfüllen können, d. h. insbesondere, dass:
- die Haftfestigkeit zwischen der Trennschicht und dem Wafer die geringste Haftfestigkeit zwischen zwei Schichten im ganzen Schichtsystem darstellt, so dass die Sollbruchstelle zwischen Trennschicht und Wafer vorgegeben ist,
- dass die Schicht aus Elastomermaterial beim Verbinden des Schichtsystems mit dem Wafer eine Konsistenz besitzt, die sicherstellt, dass die Oberflächenstrukturen des Wafers im erforderlichen Maße umschlossen werden,
- dass die Schicht aus Elastomermaterial nach dem Aushärten das Schichtsystem ausreichend stabilisiert für die weitere Bearbeitung des Wafers, und dass sie insbesondere stabil genug ist, dass beim Lösen des Wafers von der Trennschicht (oder umgekehrt) die Schicht aus Elastomermaterial nicht reißt und
- dass die Trägerschicht die Wafer-Träger-Anordnung ausreichend stabilisiert.

Unter Umständen kann die Schicht aus Elastomermaterial auch die Funktion der Trägerschicht mit übernehmen.

Letztendlich ermöglicht die erfindungsgemäße Wafer-Träger-Anordnung unter den vorgenannten Voraussetzungen, dass die Rückseitenbearbeitung des Wafers wesentlich leichter erfolgen kann, da die Handhabung einfach ist und ein geeignetes Stabilisierungsschichtsystem vorhanden ist. Insbesondere ist es möglich, den Wafer stärker zu Dünnen, da aufgrund der plasmapolymeren Trennschicht bei der Trennung des Wafers vom Schichtsystem ein verhältnismäßig geringer (und durch die Wahl der plasmapolymeren Schicht weitgehend steuerbarer) mechanischer Stress auftritt.

Hinsichtlich der Trennschicht sei noch angemerkt, dass es für den Fachmann selbstverständlich nachvollziehbar ist, dass es nicht zwingend ist, dass die plasmapolymere Trennschicht entweder auf dem Wafer oder die Schicht aus Elastomermaterial abgeschieden wird. Grundsätzlich kann die Trennschicht auch zunächst unabhängig von Wafer und Schicht aus Elastomermaterial hergestellt werden und nachfolgend mit diesen z. B. durch Verpressen verbunden werden. Es ist aber bevorzugt, die Trennschicht auf die Waferoberfläche abzuscheiden, da so am besten die Konturnachbildung der Waferoberfläche durch die plasmapolymere Trennschicht gewährleistet ist.

Bevorzugt ist auch eine erfindungsgemäße Wafer-Träger-Anordnung, umfassend auf der von der Trennschicht abgewandten Seite des Wafers (Rückseite des Wafers) eine Verbindungsmaterialschicht und eine zweite Trägerschicht.

Es ist leicht nachvollziehbar, dass die gerade beschriebene Wafer-Träger-Anordnung sinnvollerweise erst nach dem Bearbeiten der Rückseite des Wafers erzeugt wird. Dabei ist zu betonen, dass die zweite Trägerschicht stofflich völlig verschieden von der ersten Trägerschicht sein kann. Die Verbindungsmaterialschicht dient dazu, die zweite Trägerschicht mit dem Wafer zu verbinden. Entscheidend für dieses Material, das unterschiedlich ausgestaltet sein kann, ist, dass es eine auf geeignete Weise lösbare Verbindung zwischen der zweiten Trägerschicht und dem Wafer gewährleistet. So kann die Verbindungsmaterialschicht beispielsweise eine Schicht aus einem UV- oder Thermorelease-Kleber sein, der bei Einstrahlung von UV-Licht bzw. Einwirken thermischer Energie seine Haftkraft verringert bzw. verliert. Bevorzugt ist in diesem Zusammenhang selbstverständlich, dass möglichst wenig, besonders bevorzugt nichts, von der Verbindungsmaterialschicht auf dem Wafer verbleibt, nachdem die Haftkraft entsprechend verringert wurde. Gegebenenfalls kann die Verbindungsmaterialschicht ihrerseits eine plasmapolymere Trennschicht darstellen, die zur zweiten Trägerschicht eine größere Haftkraft besitzt als zum Wafer.

Vorteil dieser zweiten Trägerschicht kann sein, dass sie die Handhabung des gedünnten und/oder vereinzelten Wafers erleichtert sowie gegebenenfalls das Trennen des Schichtsystems auf der Vorderseite des Wafers vom Wafer ermöglicht oder unterstützt (siehe dazu auch weiter unten).

Ein Vorprodukt für die Erfindung ist auch ein Trägerschichtsystem für eine erfindungsgemäße Wafer-Träger-Anordnung, umfassend
(i) eine Trägerschicht,
(ii) eine Schicht aus einem ausgehärteten, teilausgehärteten oder aushärtbaren Elastomermaterial und
(iii) eine abziehbare Schutzfolie auf der der Trägerschicht abgewandten Seite der Schicht aus Elastomermaterial.

Eine abziehbare Schutzfolie ist in diesem Zusammenhang eine Folie, die sich auf mechanischem Wege rückstandsfrei vom Elastomermaterial entfernen lässt.

Das beschriebene Trägerschichtsystem stellt eine Vorstufe der erfindungsgemäßen Wafer-Träger-Anordnung dar und ist dafür vorgesehen, bei der Herstellung der erfindungsgemäßen Wafer-Träger-Anordnung eingesetzt zu werden. Dies kann dadurch geschehen, dass die abziehbare Schutzfolie entfernt wird und anschließend das Trägerschichtsystem mit dem bereits mit einer plasmapolymeren Trennschicht versehenen Wafer verpresst oder anderweitig auf geeignete Art und Weise in Verbindung gebracht wird.

Insbesondere ein Vorteil an diesem Trägerschichtsystem ist, dass es aufgrund der Schutzfolie gut lagerbar und transportabel ist und auch an einer von der Waferherstellung und -bearbeitung entfernten Stelle produziert werden kann.

Ein Vorprodukt für die Erfindung ist auch ein Schichtsystem für eine erfindungsgemäße Wafer-Träger-Anordnung, umfassend
(i) eine Trägerschicht,
(ii) eine Schicht aus einem ausgehärteten, teilausgehärteten oder aushärtbaren Elastomermaterial und
(iii) eine plasmapolymere Trennschicht auf der der Trägerschicht abgewandten Seite der Schicht aus Elastomermaterial,
wobei bevorzugt auch hier eine Schutzfolie vorgesehen ist, die auf der der Trägerschicht abgewandten Seite der plasmapolymeren Trennschicht angebracht ist.

Sofern die Voraussetzungen, die weiter oben beschrieben wurden für die plasmapolymere Trennschicht zutreffen, kann auch dieses Produkt hervorragend für die Herstellung einer erfindungsgemäßen Wafer-Träger-Anordnung verwendet werden. Auch hier bestehen wieder die Vorteile, dass das Schichtsystem separat produziert werden kann und bereits als Vorprodukt eingesetzt werden kann.

Ein vorteilhaftes Ausführungbeispiel der Erfindung ist eine Wafer-Träger-Anordnung, wobei das Elastomermaterial im teilausgehärteten Zustand eine *signifikant niedrigere* Shore-A-Härte als im ausgehärteten Zustand mit einer materialtypischen Shore-A-Härte von 15 bis 78, bevorzugt 20 bis 70, weiter bevorzugt 30 bis 60 und besonders bevorzugt 40 bis 55 besitzt.

Unter einer signifikant niedrigeren Shore-A-Härte für den teilausgehärteten Zustand ist eine um wenigstens 10%, bevorzugt 20% und besonders bevorzugt 40% geringere Shore-A-Härte als die des ausgehärteten Zustandes zu verstehen. Für viele Anwendungen besonders bevorzugt ist, dass praktisch keine Shore-A-Härte im teilausgehärteten Zustand vorliegt, da das Elastomermaterial (noch) kein Formhärtkörper mit einer Shore-A-Härte im klassischen Sinne ist, sondern in einem pastösen gegebenenfalls sogar fließfähigen Zustand vorliegt.

Wie weiter oben beschrieben, dient der teilausgehärtete Zustand der Schicht aus Elastomermaterial dazu, dem Elastomermaterial eine geeignete Konsistenz zu vermitteln, so dass es die (durch eine plasmapolymere Trennschicht bedeckte) Waferoberflächentopographie im ausreichenden Maße umschließt, andererseits beim Laminieren ader nicht verfließt.

Der teilausgehärtete Zustand des Elastomermaterials kann auf verschiedene Weisen erzeugt werden: Sofern die Aushärtung (z. B. Polymerisation) des Elastomermaterials thermisch kontrolliert geschieht, wird nur solange thermische Energie dem Elastomermaterial zugeführt, bis der gewünschte teilausgehärtete Zustand erreicht ist. Gegebenenfalls kann auch eine entsprechende Aushärtungs-(Polymerisations-)Reaktion durch gezielten Entzug von Wärme wie z. B. Kühlen unterbrochen oder im gewünschten Maße verlangsamt werden. Dies gilt insbesondere dann, wenn die Aushärtungsreaktion lediglich wärmeinduziert ist.

Als Alternative bietet es sich an, Elastomermaterialien zu verwenden, die mittels zweier Mechanismen ausgehärtet werden (polymerisiert und/oder vernetzt) werden können. Dies kann beispielsweise durch das Vorsehen verschiedener reaktiver Gruppen im aushärtbaren Elastomermaterial erreicht werden: So ist es beispielsweise möglich, zunächst eine UV-vermittelte Aushärtung/Polymerisation/Vernetzung ablaufen zu lassen, und erst nach Kontaktieren der Waferoberfläche (selbstverständlich vermittelt durch die plasmapolymere Trennschicht) den zweiten Reaktionsmechanismus z. B. einen chemischen zu starten.

Für viele Anwendungen kann es auch bevorzugt sein, ein aushärtbares Elastomermaterial einzusetzen, das während des Aushärtungsprozesses oder wenigstens während Teilen des Aushärtungsprozesses auf ständige Energiezufuhr (z. B. Licht/UV-Licht/Wärme) angewiesen ist, um den Aushärtungsprozess aufrechtzuerhalten.

Erfindungsgemäß bevorzugt ist eine erfindungsgemäße Wafer-Träger-Anordnung, wobei das Elastomermaterial auf Silikonbasis oder auf Basis eines hinsichtlich seiner Eigenschaften ähnlichen Materials wie Silikon hergestellt ist.

Die Eigenschaften auf die es in diesem Zusammenhang ankommt sind hierbei insbesondere mechanische Festigkeit, Temperaturbeständigkeit, Vakuumverträglichkeit und geringe chemische Reaktionsfähigkeit gegenüber anderen Materialien.

Bevorzugte Materialien für das Elastomermaterial sind Silikonelastomere, Gummi und dem Kautschuk ähnliche Materialien.

Bevorzugt ist auch eine erfindungsgemäße Wafer-Träger-Anordnung, wobei die Trägerschicht eine Polyimid- oder Polyamidschicht, bevorzugt in Form einer Kapton- oder Ultemfolie, eine Glasschicht oder eine Siliziumschicht ist.

Besonders bevorzugt ist eine erfindungsgemäße Wafer-Träger-Anordnung, bei der der Wärmeausdehnungskoeffizient bei 20°C für die Längsdehnung der Trägerschicht von dem des Wafers um maximal 10,0 *10⁻⁶ /° C bevorzugt maximal 5 *10⁻⁶ /° C, weiter bevorzugt maximal 2,5 *10⁻⁶ /° C, besonders bevorzugt maximal 1,8 *10⁻⁶ /° C abweicht.

Der Vorteil der letztgenannten erfindungsgemäßen Wafer-Träger-Anordnung besteht darin, dass durch die Wärmeausdehnungskoeffizienten abhängige Auswahl des Materials für die Trägerschicht dafür gesorgt wird, dass zwischen dem Wafer und der Trägerschicht geringe oder bevorzugt keine mechanischen Spannungen entstehen, die auf der unterschiedlichen Ausdehnung der Materlianen beruhen.

Bevorzugt sind dementsprechend für die Trägerschicht Glas bzw. modifiziertes Glas, das hinsichtlich seines Wärmeausdehnungskoeffizienten nur geringe Differenzen zu dem Wärmeausdehnungskoeffizienten des Wafers besitzt oder das gleiche Material, aus dem der Wafer im Wesentlichen gebildet wird. Idealerweise kommen hierbei Gläser wie Borofloat 33 des Anbieters Planoptik zur Anwendung die bei Raumtemperatur von 20 °C einen Wärmeausdehnungskoeffizienten von 3,2 *10⁻⁶ /° C aufweisen um damit den Wärmeausdehnungskoeffizienten des Siliziums sehr nahe kommen.

Besonders bevorzugt ist in diesem Zusammenhang jedoch ein entsprechend hinsichtlich seines Wärmeausdehnungskoeffizienten angepasstes Glas, da dieses im Regelfall verhältnismäßig preisgünstig und darüber hinaus auch durchlässig für Licht und/oder UV-Licht sein kann, mittels dessen die Schicht aus Elastomermaterial (teil-)ausgehärtet werden kann.

Bevorzugt ist auch eine erfindungsgemäße Wafer-Träger-Anordnung, wobei die zweite Trägerschicht eine Folie ist und besonders bevorzugt wobei die Biegsamkeit der zweiten Trägerschicht größer ist, als die der ersten.

Ein Biegsamkeitsvergleich wird wie folgt durchgeführt: Es werden zum Vergleich der Biegsamkeit der beiden Schichten aus dem Material, aus dem die Schichten bestehen, jeweils ein Körper identischer Länge und Breite und jeweils in Höhe der jeweiligen Schichtdicke erzeugt. Bevorzugt sind diese Köper langgestreckt. Nachfolgend wird ein Ende des Körpers fixiert, während auf das andere eine definierte Kraft ausgeübt wird. Derjenige Körper, der durch die ausgeübte Kraft am nicht fixierten Ende eine höhere (elastische) Auslenkung aus der ursprünglichen Ebene erleidet, besitzt die größere Biegsamkeit. Dabei bezieht sich die Biegsamkeit ausdrücklich auf elastische Verformung und nicht inelastische wie z. B. Knicken.

Insbesondere für den Fall, dass die Trägerschicht aus wenig flexiblem/wenig biegsamen Material wie z. B. Glas besteht, ist es für eine mechanische Enthaftung des Wafers von der Trennschicht von Vorteil, wenn der (abgedünnte) Wafer zusammen mit dem Schichtsystem auf seiner Rückseite gebogen werden kann, so dass der Wafer zum einen durch die Trägerschicht auf seiner Rückseite geschützt ist, zum anderen aber mechanische Scherkräfte auftreten, die das Lösen der Verbindung zwischen Wafer und Trennschicht erleichtern. Selbstverständlich kann der Trennvorgang durch ein mechanisches Hilfsmittel wie z. B. eine Umlenkrolle unterstützt werden (s. dazu auch weiter unten) und es ist außerdem vorteilhaft, die Trägerschicht zu fixieren.

Besonders bevorzugte Materialien für die zweite Trägerschicht sind in diesem Zusammenhang Folien aus einer oder mehreren Lagen aus PP, PE, PET und/oder anderen Kunststoffen. Bevorzugt sind die Materialien für die zweite Trägerschicht expansionsfähig. Beispiele für solche Folien sind Sägefolien (branchenüblich auch "bluetape" genannt), wie sie von Herstellen wie z. Lintec oder Nitto angeboten werden.

Bevorzugt ist eine erfindungsgemäße Wafer-Träger-Anordnung mit einer zweiten Trägerschicht, wobei die Verbindungsmaterialschicht ein Material, bevorzugt einen Kleber, umfasst oder aus diesem besteht, das/der seine Haftkraft zu dem Wafer unter der Einwirkung von Strahlung und/oder Wärme verringert oder verliert.

Diese bevorzugte Verbindungsmaterialschicht ermöglicht ein wiederum bevorzugt rückstandsfreies Trennen in der zweiten Trägerschicht vom Wafer. Dieses Trennen erfolgt regelmäßig nachdem die Trennung zwischen Wafer und der plasmapolymeren Trennschicht erfolgt ist. Letztendlich lässt sich auf diese Weise der Wafer ohne das für die Prozessierung vorgesehene Schichtsystem erhalten.

Für viele Anwendungen ist eine erfindungsgemäße Wafer-Träger-Anordnung bevorzugt, wobei die Trägerschicht und/oder die Schicht aus Elastomermaterial und/oder die zweite Trägerschicht so ausgestaltet sind, dass sie sich elektrostatisch aufladen lassen und/oder von elektrostatisch aufgeladenen Flächen fixieren lassen.

Zur bevorzugten Ausgestaltung (elektrostatische Aufladbarkeit) der entsprechenden Schichten stehen dem Fachmann eine Reihe von Möglichkeiten zur Verfügung. Zum einen kann der gewünschte Effekt durch die Auswahl des (Haupt-)Materials für die jeweilige Schicht erzielt werden oder durch Einbringen entsprechender elektrostatisch aufladbarer Partikel in eine oder mehrere der erwähnten Schichten.

Der Vorteil dieser bevorzugten Ausführungsform der Erfindung liegt darin, dass mittels der elektrostatischen Eigenschaften der Schichten Wechselwirkungen mit elektrostatisch aufgeladenen Oberflächen erzeugt werden können und die erfindungsgemäße Wafer-Träger-Anordnung fixiert werden kann (z. B. für den Transport). Selbstverständlich kann sie auch für verschiedene Prozesse wie z. B. das Abdünnen oder das Rückseitenmetallisieren gehaltert werden. Besonders vorteilhaft stellt sich die elektrostatische Fixierung für Prozessieren unter Vakuumbedingungen dar.

+Bevorzugt ist auch ein Schichtsystem mit einer Schutzfolie, wobei die Schutzfolie zum Beispiel ein Silikon beschichtetes Papier sein kann oder eine aus PP, PE, PET oder einem anderen Kunststoff bestehende Folie sein kann. Entscheidende Eigenschaft der Folie ist, sich leicht und bevorzugt rückstandsfrei wieder von der elastomeren Schicht der Trägers ablösen zu lassen.

Teil der Erfindung ist auch die Verwendung einer erfindungsgemäßen Wafer-Träger-Anordnung bei der Bearbeitung der Rückseite eines Wafers, bevorzugt beim Dünnen und/oder Vereinzeln eines Wafers, wie in Anspruch 7 definiert.

Darüber hinaus von Interesse ist ein Verfahren zum Herstellen eines Schichtsystems, umfassend die Schritte:
a) Formen einer Trägerschicht,
b) Formen einer Schicht aus aushärtbarem Elastomermaterial,
c) Verbinden der in Schritt a) und b) entstandenen Schichten, bevorzugt gleichzeitig mit Schritt a) oder b),
d) gegebenenfalls Aushärten oder Teilaushärten der Schicht aus aushärtbarem Elastomermaterial,
e) gegebenenfalls Abscheiden einer plasmapolymeren Trennschicht auf der der Trägerschicht abgewandten Seite der Schicht aus Elastomermaterial und
f) gegebenenfalls Anbringen einer abziehbaren Schutzfolie auf der der Trägerschicht abgewandten Seite der Schicht aus Elastomermaterial oder auf der der Trägerschicht abgewandten Seite der plasmapolymeren Trennschicht.

Für den Fachmann ist dabei leicht nachvollziehbar, dass die als gegebenenfalls gekennzeichneten Schritte jeweils in Abhängigkeit davon durchzuführen sind, welche der (gegebenenfalls bevorzugten) Ausführungsformen des Schichtsystems bei dem Verfahren hergestellt werden sollen.

Insbesondere ist im Schritt d) bevorzugt, dass die Schicht aus aushärtbarem Elastomermaterial teilausgehärtet wird, um ihre Aufgaben optimal zu erfüllen und nach Inkontaktbringen mit der Waferoberfläche (vermittelt durch die plasmapolymere Trennschicht) ausgehärtet werden zu können.

Teil der Erfindung ist auch ein Verfahren zum Herstellen einer erfindungsgemäßen Wafer-Träger-Anordnung, wie in Anspruch 8 definiert. Entscheidend sind bei den beschriebenen erfindungsgemäßen Verfahren, dass der Fachmann die Auswahl der Materialien für die jeweiligen Schichten unter den weiter oben genannten Gesichtpunkten insbesondere bezüglich ihrer Funktion auswählt. Auch den Umfang des Aushärtens des Elastomermaterials, bevorzugt über zunächst eine Teilaushärtung und eine spätere Aushärtung, wird der Fachmann den jeweiligen Gegebenheiten anpassen.

Anzumerken ist noch, dass zum Erzeugen und Verbinden der jeweiligen Schichten dem Fachmann diverse Möglichkeiten zur Verfügung stehen. So kann das Laminieren beispielsweise über Verpressen, Kleben oder chemisches Anbinden erfolgen, wobei stets die weiter oben beschriebenen Voraussetzungen hinsichtlich der Haftfestigkeiten der Schichten zueinander erfüllt sein müssen, damit die Schichten ihre erfindungsgemäße Funktionen erfüllen können.

Auch für das Erzeugen der Schichten stehen dem Fachmann je nach Materialauswahl verschiedene Möglichkeiten zur Verfügung, so können Schichten beispielsweise zunächst flüssig in Form von geeigneten spin- oder spraycoating-Verfahren zum Aufbringen flüssiger Materialien aufgebracht werden, sie können aber von vornherein auch in Form einer Folie aufgebracht werden. Sofern die oben genannten Funktionen der Schichten nicht beeinträchtigt werden, ist auch der Einsatz von haftvermittelnden oder haftherabsetzenden Substanzen möglich und je nach zu erzielender Funktion der Schicht auch sinnvoll.

Teil der Erfindung ist auch ein Verfahren zum Bearbeiten der Rückseite eines Wafers wie in Anspruch 9 definiert, umfassend die Schritte:
a) Herstellen einer erfindungsgemäßen Wafer-Träger-Anordnung, die auf der Rückseite des Wafers (noch) keine Verbindungsmaterialschicht und keine zweite Trägerschicht umfasst, und
b) Bearbeiten der Rückseite des Wafers.

Bevorzugt wird in dem letztgenannten erfindungsgemäßen Verfahren die Rückseite des Wafers gedünnt. Dies kann durch herkömmliche Verfahren wie z. B. Grinden, Schleifen, Läppen oder Ätzen geschehen.

Selbstverständlich sind auch andere Maßnahmen zur Bearbeitung der Rückseite des Wafers aufgrund der erfindungsgemäßen Wafer-Träger-Anordnung gut möglich, dazu zählt z. B. das Metallisieren der Rückseite, das Strukturieren der Rückseite mittels Ätzen und das Dotieren der Rückseite.

Für den Fachmann ist es unmittelbar nachvollziehbar, dass viele der Schritte des erfindungsgemäßen Verfahrens auch unter Vakuumbedingungen durchgeführt werden können. Dies gilt bevorzugt für das Verbinden (insbesondere das Verpressen) der Schicht aus Elastomermaterial mit dem Wafer, wobei unerheblich ist, ob die plasmapolymere Trennschicht, die zwischen Wafer und der Schicht aus Elastomermaterial vorgesehen ist, zum Zeitpunkt des Kontaktierens sich auf den Wafer oder auf der Schicht aus Elastomermaterial befindet.

Bevorzugt ist ein erfindungsgemäßes Verfahren, wobei nach erfolgter Rückseitenbearbeitung der Waferrückseite auf der Rückseite des Wafers eine Verbindungsmaterialschicht und eine zweite Trägerschicht angebracht wird.

Selbstverständlich werden die letztgenannten Schichten so angebracht, dass die Haftfestigkeit dieser Schichten zueinander und zum Wafer größer ist als die Haftfestigkeit zwischen dem Wafer und der plasmapolymeren Trennschicht.

Dementsprechend ist ein erfindungsgemäßes Verfahren zum Bearbeiten der Rückseite eines Wafers bevorzugt, bei dem nach dem Schritt b) und gegebenenfalls nach dem Schritt c) eine Trennung zwischen dem Wafer und der plasmapolymeren Trennschicht erfolgt.

Besonders bevorzugt ist dieses Verfahren in dem Fall, dass die Trägerschicht eine wenig flexible Schicht ist wie z. B. eine Glasplatte. Insbesondere wenn eine zweite Trägerschicht, eingesetzt wird, die biegsamer als die Trägerschicht ist, lässt sich das Abtrennen des Wafers von der Trennschicht entsprechend dem bevorzugten erfindungsgemäßen Verfahren gut wie nachfolgend beschrieben durchführen:
Die Trägerschicht wird auf ihrer vom Wafer abgewandten Seite fixiert. Dieses kann beispielsweise insbesondere bei Glasplatten als Trägerschicht durch Ansaugen mittels Vakuum erfolgen. Es ist aber auch beispielsweise eine mechanische Halterung durch Einspannen möglich. Nun wird die zweite Trägerschicht, die bevorzugt in Form einer Folie vorliegt, mittels einer geeigneten Vorrichtung angehoben. Eine solche Vorrichtung kann z. B. eine Umlenkrolle sein, die hinsichtlich ihres Radius so ausgelegt ist, dass sie beim Biegen des Systems aus Wafer, Verbindungsmaterialschicht und zweiter Trägerschicht auf den Wafer nur Kräfte einwirken lässt, die eine Beschädigung des Wafers aufgrund mechanischen Stresses unwahrscheinlich macht oder sogar ausschließt. Dabei ist es selbstverständlich nachvollziehbar, dass je stärker der Wafer abgedünnt ist, d. h. je dünner er vorliegt, er desto höhere Biegung verträgt.

Durch das Anheben des Systems aus zweiter Trägerschicht, Verbindungsmaterialschicht und Wafer erfolgt eine Trennung an der Sollbruchstelle zwischen plasmapolymerer Trennschicht und Wafer. Bevorzugt erfolgt wie schon angedeutet diese Trennung mechanisch. Dabei kann beispielsweise im Falle des Einsatzes einer Umlenkrolle die Vorschubgeschwindigkeit so gewählt werden, dass der Wafer nicht überlastet wird, die plasmapolymere Trennschicht aber vollständig vom Wafer entfernt wird. Nach der Trennung liegt die Wafervorderseite ohne das für die Prozessierung angebrachte Schichtsystem vor und kann gegebenenfalls weiterverarbeitet werden.

Bevorzugt ist ein erfindungsgemäßes Verfahren, bei dem nach Trennung des Wafers von der Trennschicht auch die zweite Trägerschicht abgetrennt wird. Dies geschieht bevorzugt unter Herabsetzung der Haftkraft zwischen der Verbindungsmaterialschicht und dem Wafer. Im Falle eines Klebers, der beispielsweise durch UV-Strahlung oder thermische Energie seine klebende Wirkung verringert oder verliert, wird die Haftkraft durch UV-Strahlung bzw. das Zuführen thermischer Energie herabgesetzt. Dies ist auch Teil eines bevorzugten erfindungsgemäßen Verfahrens.

Bevorzugt ist darüber hinaus ein erfindungsgemäßes Verfahren, bei dem der Wafer vor Ablösen der plasmapolymeren Trennschicht und/oder vor Ablösen der zweiten Trägerschicht vereinzelt wird. Dies kann beispielsweise dadurch geschehen, dass nach Abtrennen der plasmapolymeren Trennschicht mittels geeigneter Verfahren (vgl. dazu z. B. weiter oben) der Wafer in Mikroplättchen (Dies) getrennt wird. Eine entsprechende Trennung kann aber auch schon vor Anbringen der zweiten Trägerschicht erfolgen, während die plasmapolymere Trennschicht noch am Wafer haftet.

Vorteil an diesem Verfahren ist, dass der vereinzelte Wafer (das heißt eigentlich seine vereinzelten Teile), solange er noch in Kontakt mit der Trägerschicht oder der zweiten Trägerschicht ist, zusammengehalten wird, also die einzelnen Dies vom jeweiligen Schichtsystem gehalten werden. Für den Fachmann ist es natürlich nachvollziehbar, dass es in vielen Fällen sinnvoll ist, das jeweilige Schichtsystem nicht oder wenigstens nicht vollständig beim Vereinzeln des Wafers zu durchtrennen.

Nachfolgend werden noch weitere Hinweise im Zusammenhang mit dem erfindungsgemäßen Verfahren und der Herstellung der erfindungsgemäßen Wafer-Träger-Anordnung bzw. des Schichtsystems gegeben:
- Einsatz eines flüssigen Precursors:
   Wie bereits in der WO 2004/051708 A2 beschrieben, kann zum Einstellen der Adhäsionseigenschaften (bzw. Dehäsionseigenschaften, Trenneigenschaften) der plasmapolymeren Schicht der Einsatz eines flüssigen Precursors sinnvoll sein. Als flüssiger Precursor eignen sich im Rahmen der vorliegenden Erfindung insbesondere Mischungen aus Silikonöl mit einem geeigneten Lösungsmittel.
   Der flüssige Precursor kann z. B. mittels spincoating, spraycoating, wobei jeweils der Wafer rotiert wird, Flutens, wobei die Waferoberfläche von oben mit dem Precursor geflutet wird, oder Tauchens, wobei der Wafer in den Precursor getaucht wird (gegebenenfalls mit folienbedeckter Rückseite) auf dem Wafer aufgebracht werden.
   Dabei ist es für viele Anwendungen vorteilhaft, den Precursor so auf den Wafer aufzubringen, dass im Bereich kritischer Hinterschneidungen bzw. an
   Stellen, die beim Trennen zwischen Wafer und plasmapolymerer Trennschicht besonders hohen Scherwirkungen ausgesetzt sein können, eine stärkere Precursorschicht zu erzeugen.
   Der Precursor wird wie in der oben genannten Offenlegungsschrift beschrieben gegebenenfalls vernetzt, was auch mittels des Plasmas beim Abscheiden der plasmapolymeren Trennschicht erfolgen kann. Sofern die Precursorschicht an einigen Stellen stärker (dicker) ist, kann das Abscheidungsverfahren bzw. das Vernetzungsverfahren so gestaltet werden, dass an den besonders kritischen Stellen der Precursor nicht oder nicht vollständig vernetzt ist. Er liegt damit noch z. B.: als Öl bzw. in teilvernetzter Form vor und verringert an den besonders kritischen Stellen zusätzlich die Haftung zwischen Waferoberfläche und Trennschicht. Dadurch wird die Trennung zwischen Wafer und Trennschicht insbesondere an topographisch kritischen Stellen nochmals erleichtert.
   Nach dem Auftragen des Precursors kann es bevorzugt sein, das Lösungsmittel ausdampfen zu lassen (sofern der Precursor ein Lösungsmittel umfasst). Dieses kann beispielsweise erfolgen durch Absaugen der Lösungsmitteldämpfe, Verbringen in einer Vakuumkammer oder unter thermischer Unterstützung durch Erwärmen.
- Elastomermaterial:
   Bevorzugtes Elastomermaterial sind silikonbasierte Elastomere wie z. B. selbsthaftender Flüssigsilikonkautschuk des Herstellers Wacker, Burghausen, Typ ELASTOSIL LR 3070 oder LR 3070. Alternativ können aber Gummi-, Kautschuk- oder sonstige Materialien mit elastomeren Eigenschaften im ausgehärteten Zustand eingesetzt werden. Selbstverständlich können auch geeignete Mischungen oder Schichtverbunde aus verschiedenen Elastomermaterialien eingesetzt werden.
   Die Schicht aus Elastomermaterial wird selbstverständlich Ihrer Shore-Härte sowohl in teilausgehärteten als auch in ausgehärtetem Zustand an ihre jeweilige Funktion angepasst (vgl. weiter oben). Hierzu stehen dem Fachmann die geeigneten Materialien und Möglichkeiten zur Verfügung. Sofern der zu bearbeitende Wafer beispielsweise auf seiner Oberfläche Bums besitzt, die z. B. eine Höhe von 50 µm haben, ist eine Shore-Härte zwischen 20 und 60 vorteilhaft. Selbstverständlich ist dem Fachmann klar, dass die Dicke der Schicht aus Elastomermaterial die Höhe der Bums ausreichend übertreffen muss.
   Das Aufbringen der Schicht aus aushärtbarem Elastomermaterial kann beispielsweise über Rakeln erfolgen. Das Vernetzen dieser Schicht kann wie weiter oben bereits beschrieben über mehrere Schritte (Teilaushärten, Aushärten) erfolgen. Zum Beispiel lassen sich die oben genannten Silikonkautschuke des Herstellers Wacker, Burghausen, mittels einer Presse bei 165°C innerhalb von 5 Minuten Vulkanisieren und damit vernetzen/aushärten.
   Analog zum Teilvernetzen ist auch ein temporäres Verfestigen der Schicht aus Elastomermaterial denkbar, beispielsweise durch Abkühlen oder Gefrieren. Diese Prozesse können wie weiter oben bereits angedeutet auch zur Unterbrechung der Aushärtungsreaktion (Vernetzungsreaktion) eingesetzt werden. Bevorzugt erfolgt ein entsprechendes Abkühlen in trockener Atmosphäre gegebenenfalls unter Schutzgasatmosphäre, um den Niederschlag von Luftfeuchtigkeit zu verhindern.
   Sofern die Schicht aus Elastomermaterial heruntergekühlt wurde, ist beim oder vor dem Inkontaktbringen dieser Schicht mit der Waferoberfläche (beispielsweise durch Verpressen) ein Erwärmen/Auftauen beispielsweise unter Schutzglasatmosphäre sinnvoll.
- Laminieren:
   Das Laminieren kann mittels eines Bonders erfolgen, wobei die Parameter Vakuum, Temperatur, UV-Licht, Druck oder Dauer der Laminierung je nach Bedarf eingesetzt und/oder vom Fachmann gewählt werden.
- Schichtdickeneinstellung der Schicht aus Elastomermaterial:
   Dies kann bevorzugt mittels mechanischen Anschlags und/oder paralleler Führung der beiden Pressstempel eines Bonders erfolgen.
   Es kann sinnvoll sein, eine Kontrolle der Stärke (Höhe) der erfindungsgemäßen Wafer-Träger-Anordnung zu Qualitätssicherungszwecken durchzuführen.
- Zweite Trägerschicht:
   Als zweite Trägerschicht können Sägefolien eingesetzt werden, bevorzugt solche, die Expansionseigenschaften besitzen (auch bluetape genannt). Derartige Sägefolien werden von Herstellern wie Lintec, Nitto oder Advantek angeboten. Bevorzugt werden als zweite Trägerschicht Folien des Herstellers Advantek mit einer Klebeschicht eingesetzt, z. B. solche mit einem drucksensitiven Adhäsiv (z. B. Typ DX112A) oder UV -sensitiven Adhäsiv (z. B. Typ DU099D). Die Haftkraft dieser Sägefolie als zweite Trägerschicht beträgt 700 gr. gemessen nach der Methode ASM D 1000. Unter Berücksichtigung dieser Klebkraft ist eine Trennung zwischen plasmapolymerer Trennschicht und Wafer unter Ausübung von Zug auf die zweite Trennschicht (vgl. auch weiter unten) möglich.
- Wichtig in diesem Zusammenhang ist, dass die (gegebenenfalls durch die Verbindungsmaterialschicht vermittelte) Haftkraft des Wafers zur zweiten Trägerschicht groß genug ist, dass sie die Haftkraft des Wafers zur Trennschicht (auch unter Einbeziehung der Entformungskräfte, wie sie z. B. beim Entformen von Bums auftreten), übertrifft. Sofern die zweite Trägerschicht aus einer Sägefolie des Typs DU099D besteht, kann durch Bestrahlung mit UV-Licht die Haftung von ursprünglich 700 gr. auf 20 gr., gemessen nach der Methode ASM D 1000, abgesenkt werden und damit die Trennung der zweiten Trägerschicht von dem Wafer vorbereitet werden. Nachfolgend wird die Erfindung anhand von Zeichnungen und einem Beispiel näher erläutert. Selbstverständlich ist die Erfindung nicht auf die Zeichnungen und/oder das Beispiel beschränkt.

Es stellen dar:
Figur 1 ein Schichtsystem für eine Wafer-Träger-Anordnung,
Figur 2 eine erfindungsgemäße Wafer-Träger-Anordnung,
Figur 3 eine schematische Darstellung eines möglichen Trennvorganges, bei dem eine Trennung zwischen dem Wafer und der plasmapolymeren Trennschicht erfolgt.

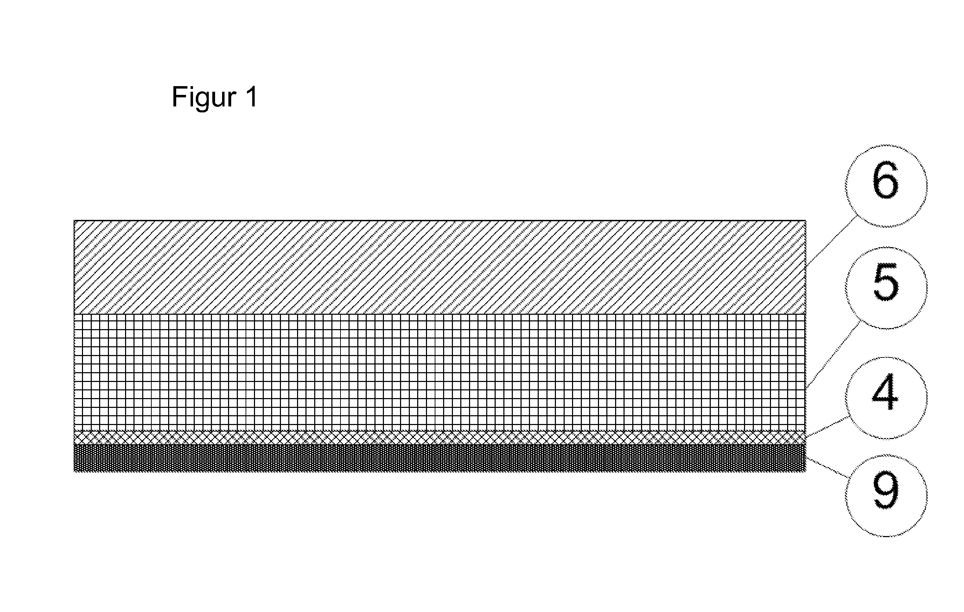

Das in Figur 1 dargestellte Schichtsystem umfasst eine Trägerschicht 6, eine Schicht 5 aus einem ausgehärteten, teilausgehärteten oder aushärtbaren Elastomermaterial, eine plasmapolymere Trennschicht 4 und eine abziehbare Schutzfolie 9.

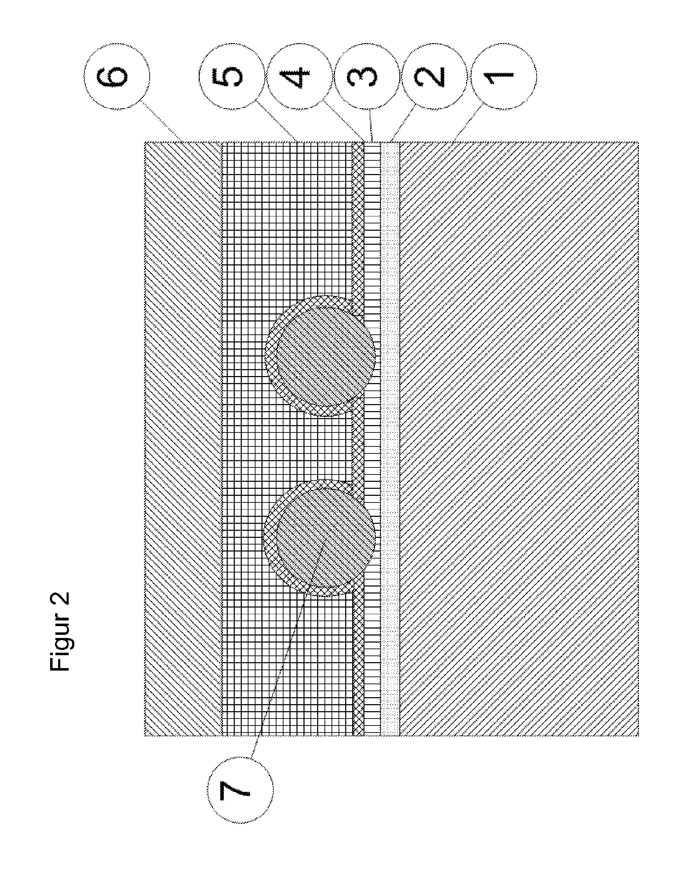

Die in Figur 2 dargestellte Wafer-Träger-Anordnung umfasst einen Wafer 1, der eine aktive Zone 2 mit elektronischen und/oder mechanischen Funktionselementen und eine Passivierungsschicht 3 umfasst, eine plasmapolymere Trennschicht 4, die die Oberfläche des Wafers einschließlich von Bumps 7 konturnachbildend bedeckt, eine Schicht 5 aus aushärtbarem, teilausgehärtetem oder ausgehärtetem Elastomermaterial und eine Trägerschicht 6.

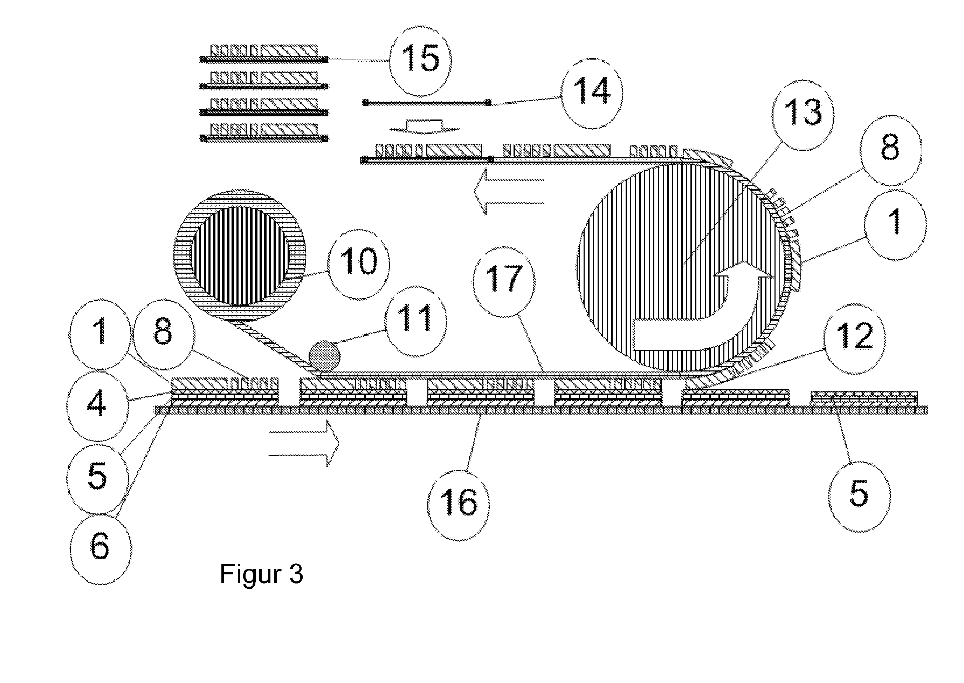

Die Figur 3 ist eine schematische Darstellung eines Trennprozesses, bei dem die Trennung zwischen dem Wafer und der plasmapolymeren Trennschicht erfolgt. Dabei werden Wafer 1 dargestellt, die bereits zum Teil vereinzelt sind (8) und auf ihrer Vorderseite mit einer plasmapolymeren Trennschicht 4, einer Schicht aus ausgehärtetem Elastomermaterial 5 und einer Trägerschicht 6 verbunden sind. Die Trägerschicht 6 ist bevorzugt eine Glasplatte. Die Trägerschicht 6 ist auf einer Unterlage 16 (z. B. einem Förderband) fixiert. Die zweite Trägerschicht 17 wird über eine Umlenkrolle 11 auf die Rückseite des bereits abgedünnten Wafers 1, 8 von einer Rolle 10 auflaminiert. Die Verbindungsmaterialschicht ist nicht gesondert dargestellt. Die zweite Trägerschicht liegt als Folie vor. Nach dem Auflaminieren wird die so entstandene Wafer-Träger-Anordnung beispielsweise durch eine Bewegung der Unterlage 16 an eine Abnehmerwalze 13 herangeführt, wobei die zweite Trägerschicht 17 180° über die Abnehmerwalze 13 geführt wird, während die Unterlage 16 ohne Richtungswechsel an der Abnehmerwalze vorbeigeführt wird. Durch diese Anordnung erfolgt eine Trennung an der Stelle 12 zwischen der plasmapolymeren Trennschicht 4 und dem Wafer 1, 8. Der Wafer verbleibt haftend an der zweiten Trägerschicht 17 und kann nachfolgend in einen Rahmen 14 überführt werden.

Die dadurch entstehenden gerahmten Folien mit den Wafer(bestandteilen) 1, 8 entsprechen den in der Halbleiterindustrie üblichen Filmframes 15 und ermöglichen eine vereinfachte Handhabung und einen vereinfachten Transport. Bei Bedarf kann durch Haftvermittlungsherabsetzung der (nicht dargestellten) Verbindungsmaterialschicht der Wafer 1 oder seine vereinzelten Teilstücke 8 (als Mikroplättchen) für die weitere Verwendung von der zweiten Trägerschicht abgelöst werden.

### Beispiel

Ein 6 Zoll Wafer mit der Dicke von ca. 700 µm soll auf eine Dicke von 50 µm gedünnt werden, seine Rückseite metallisiert, gestestet und danach mittels Sägen vereinzelt werden. Auf der Vorderseite des Wafers befinden sich Bumps mit einer Höhe von 60 µm und einer Pitch von 150 µm.

Der Wafer wird aus seiner Vorderseite mittels einer eines Spraycoaters des Herstellers Süss AG, Garching mit einem Precursor beschichtet, der aus 1 Teil Silikonöl der Type AK50 des Herstellers Wacker, Burghausen und 500 Teilen Isopropanol als Lösungsmittel besteht. Dabei ist der Spraycoater so eingestellt, dass er eine gleichmäßige Beschichtung der Waferoberfläche mit dem Precursor gewährleistet.

Nach dem Beschichten des Wafers mittels Spraycoating wird der Wafer unter eine Absaugung verbracht. Unter dieser verdampft das flüchtige Lösungsmittel und es verbleibt eine ca. 120 nm dicke Schicht aus Silkonöl auf der Waferoberfläche.

Der Wafer wird nun in eine Vakuumkammer verbracht. Diese Vakuumkammer wird nun Evakuiert, wobei letzte Reste des Lösungsmittel verdampfen und abgesaugt werden. Nachfolgend wird eine plasmapolymere Trennschicht, wie in der WO 2004/051708 offenbart, auf den Wafer abgeschieden.

Als Trägerschicht wird eine Glasscheibe mit dem Durchmesser von 6 Zoll und einer Dicke von 2,5 mm eingesetzt. Dabei weist das Glas einen Wärmeausdehnungskoeffizienten auf, der bei Raumtemperatur nahe dem von Silizium liegt.

Auf eine Seite der Glasscheibe wird eine 300 µm dicke Schicht eines Silikonkautschuks aufgetragen. Bei dem Silikonkautschuk handelt es sich um ein Material des Herstellers WACKER, Burghausen mit der Bezeichnung ELASTOSIL LR 3070 und einer Shore Härte von 50. Das Material besteht aus zwei Komponenten und muss vor seiner Anwendung im einem Mischer im Verhältnis 1 : 1 vermischt werden. Die Zweikomponentenmischung wird nun auf eine Seite der Glasplatte geschüttet. Die Glasplatte befindet sich hierbei versenkt in einer Passform. Dabei weist die Passformoberseite zu der Oberfläche der oben liegenden Seite der Glasplatte eine Höhendifferenz von ca. 300 µm auf. Mittels eines Rakel wird nun das Elastomermaterial so verteilt, dass sich auf der Glasoberfläche eine homogene Schicht von 300 µm Stärke ergibt. Der überflüssige Teil des Elastomers wird abgestrichen. Dabei ist es vorteilhaft, wenn die Materialien der Passform und des Rakel so gewählt werden, dass die nur sehr schlechte Haftung zum Elastomer aufweisen.

Die in der Passform liegende Glasscheibe und die aufgebrachte Schicht des Elastomers (Silikonkautschuk) wird nun kurzeitig auf ca. 120° C erwärmt und damit der Vulkanisierungsvorgang im Elastomer gestartet (Teilaushärtung). Damit wird erreicht, dass das Elastomer nur teilvernetzt wird und soviel Eigenfestigkeit ausweist, dass die Glassplatte der Passform entnommen werden kann, ohne dass hierbei die aufgebrachte Schicht des Elastomers durch ihr Fließverhalten ihre Form ändert.

Sofern das Schichtsystem aus Glasplatte und Elastomer (teilausgehärtet) länger gelagert werden soll, wird es nun in eine Vorrichtung gebracht, in der er bis unter minus 50° C abgekühlt werden kann. Die Vorrichtung weist hierbei eine Atmosphäre aus Stickstoff auf, um Feuchtigkeitsniederschlag in Form von Frost zu vermeiden.

Das Schichtsystem kann aber auch umgehend eingesetzt werden. Hierzu wird der vorab beschriebene Wafer mit seiner aufgebrachten Trennschicht in einen Bonder des Herstellers EVG, Schärding - Österreich auf einen Chuck so gelegt, dass seine Vorderseite - also die Seite, auf der sich die Trennschicht befindet - nach oben zeigt. Nachfolgend wird das Schichtsystem - also die Glasplatte mit der elastomeren Beschichtung - so auf die Waferoberfläche gelegt, dass die elastomere Schicht in Kontakt mit der Trennschicht ist. Der Bonder wird nun geschlossen und die Kammer, in der sich nun der Wafer mit der Trennschicht und die Glasplatte mit der elastomeren Schicht befinden, wird nun mittels Abpumpens evakuiert. Nach dem Erreichen eines ausreichenden Unterdrucks wird nun der Wafer mit dem Schichtsystem mittels zweier Chucks verpresst. Es entsteht ein blasenfreier Formschluss des Elastomers mit der Oberfläche des Wafers. Die Bumps des Wafers werden dabei vollständig von der teilvernetzten Masse des Elastomers umschlossen. Durch das Aufheizen der beiden Chucks, die den Wafer mit dem Träger verpressen auf 165° C wird das Elastomer innerhalb von 5 Minuten vollständig durchvernetzt (ausgehärtet).

Die Wafer-Träger-Anordnung kann nun dem Bonder entnommen werden. Durch die Planparallelität des Bonders ist gewährleistet, dass der Wafer zusammen mit seinem Träger eine Dickenungenauigkeit von unter 10 µm aufweist.

Die Wafer-Träger-Anordnung wird nun in einen Grinder gebracht und die freie Seite des Wafers (Rückseite) soweit dünn geschliffen, dass der Wafer eine Restdicke von 50 µm aufweist.

Um die, während des Schleifvorganges entstanden Störrungen auf der Rückseite des Wafers zu beseitigen, wird der gedünnte Wafer zusammen mit dem Trägerschichtsystem in eine Vakuumkammer gebracht, in der mittels Plasma ein Ätzangriff auf die geschliffene Seite des Wafers stattfindet, um die Schädigungen der Oberfläche zu entfernen. Vorteilhaft ist hierbei, dass die Wafer-Träger-Anordnung dabei kurzzeitig Prozesstemperaturen von bis zu 300° C aushält und sich hinsichtlich ihres Wärmeausdehnungsverhaltens in sich nicht zu stark differiert.

Der Wafer wird nachfolgend in eine Vakuumkammer gebracht und auf seiner freien Seite metallisiert.

Zum Zwecke des Ablösens des dünnen und rückseitenmetallisierten Wafers von der Trennschicht wird auf der Rückseite eine Sägefolie der Type DU099D des Herstellers Advantek mittels Laminierrolle aufgebracht. Diese Sägefolie wird an ihrer überstehende Seite fixiert. Gleichzeitig wird auch die freie Seite der Glasplatte mittels Unterdruckansaugens fixiert. Das fixierte Ende der Sägefolie wird nun um eine Umlenkrolle geführt. Dabei weist die Umlenkrolle einen Durchmesser auf, der größer ist, als der Durchmesser einer Rolle, auf der der gedünnte Wafer ohne Überlastungsbruch durch Biegung aufgelegt werden kann.

Dadurch löst sich der gedünnte Wafer von der Trennschicht, wobei die Trennschicht auf Seiten der Glasplatte verbleibt.

Die Waferoberfläche wird nun mittels eines Lösungsmittels wie Acton und reinem Wasser gereinigt.

Die Sägefolie (zweite Trägerschicht) wird nun mittels eines Rahmens gefasst und kann nunmehr zusammen mit dem auflaminierten Wafer einer Testeinrichtung zugeführt werden. Nach dem elektrischen Testen des Wafers und seiner Bauteile mittels Kontaktnadeln wird der Wafer in einer Sägevorrichtung mittels Trennschleifen in seine Bauteile zersägt. Der zersägte Wafer liegt danach auf der Sägefolie. Die Folie wird expandiert und gleichzeitig mittels Belichtung der Folie mit UV-Licht die Adhäsionseigenschaften der Folie so reduziert, dass die einzelnen Bauteile mittels Pick und Place Einrichtung abgelöst werden können.

## Patentansprüche

1. Wafer-Träger-Anordnung, umfassend:
- einen Wafer (1),
- ein Trägerschichtsystem (5, 6) und
- eine Trennschicht (4), die zwischen dem Trägerschichtsystem (5, 6) und dem Wafer (1) angeordnet ist,
wobei das Trägerschichtsystem (5, 6)
(i) eine Trägerschicht (6) und
(ii) eine Schicht (5) aus einem ausgehärteten, teilausgehärteten oder aushärtbaren Elastomermaterial trennschichtseitig umfasst oder aus diesen beiden Schichten besteht und
wobei die Trennschicht (4)
(iii) eine plasmapolymere Schicht ist und
(iv) die Haftfestigkeit zwischen dem Trägerschichtsystem (5, 6) und der Trennschicht (4) nach Aushärten des Elastomermaterials größer ist als die Haftfestigkeit zwischen dem Wafer (1) und der Trennschicht (4).

2. Wafer-Träger-Anordnung nach Anspruch 1, umfassend auf der von der Trennschicht (4) abgewandten Seite des Wafers eine Verbindungsmaterialschicht und eine zweite Trägerschicht (17).

3. Wafer-Träger-Anordnung nach einem der Ansprüche 1 oder 2, wobei das Elastomermaterial im teilausgehärteten Zustand eine um wenigstens 10 % niedrigere Shore-A-Härte als im ausgehärteten Zustand besitzt und/oder im ausgehärteten Zustand eine Shore-A-Härte von 15 bis 78 besitzt.

4. Wafer-Träger-Anordnung nach einem der Ansprüche 1, 2 oder 3, wobei das Elastomermaterial auf Silikonbasis hergestellt ist.

5. Wafer-Träger-Anordnung nach einem der Ansprüche 1 bis 4, wobei die Trägerschicht (6) eine Polyimid- oder Polyamidschicht, eine Glasschicht oder eine Siliziumschicht ist.

6. Wafer-Träger-Anordnung nach einem der Ansprüche 1 bis 5, wobei der Wärmeausdehnungskoeffizient für die Längenausdehnung der Trägerschicht (6) von dem des Wafers (1) um maximal 10 *10⁻⁶ /°C abweicht.

7. Verwendung einer Wafer-Träger-Anordnung nach einem der Ansprüche 1 bis 6 bei der Bearbeitung der Rückseite eines Wafers (1), bevorzugt beim Dünnen und/oder Vereinzeln eines Wafers (1).

8. Verfahren zum Herstellen einer Wafer-Träger-Anordnung nach einem der Ansprüche oder 3 bis 6, umfassend die Schritte:
a) Bereitstellen eines Wafers (1),
b) Bereitstellen eines Schichtsystems, umfassend eine Trägerschicht (6) und eine Schicht (5) aus einem ausgehärteten, teilausgehärteten oder aushärtbaren Elastomermaterial,
c) Abscheiden einer plasmapolymeren Trennschicht (4) auf dem Wafer (1) oder auf der Schicht (5) aus Elastomermaterial, so dass die Haftfestigkeit zwischen dem Trägerschichtsystem (5, 6) und der Trennschicht (4) nach dem Verbinden des Trägerschichtsystems (5, 6) mit dem Wafer (1), wobei die Verbindung durch die Trennschicht (4) vermittelt wird, und dem Aushärten des Elastomermaterials größer sein wird als die Haftfestigkeit zwischen dem Wafer (1) und der Trennschicht (4),
d) Verbinden des Schichtsystems mit dem gegebenenfalls mit einer plasmapolymeren Trennschicht (4) beschichteten Wafer und
e) Aushärten des Elastomermaterials.

9. Verfahren zum Bearbeiten der Rückseite eines Wafers (1), umfassend die Schritte:
a) Herstellen einer Wafer-Träger-Anordnung nach einem der Ansprüche 1 oder 3 bis 6, wobei die Trennschicht (4) an der Vorderseite des Wafers (1) angebracht ist, und
b) Bearbeiten der Rückseite des Wafers (1).

10. Verfahren nach Anspruch 9, wobei als Schritt c) nach Schritt b) auf der Rückseite des Wafers (1) eine Verbindungsmaterialschicht und eine zweite Trägerschicht (17) angebracht wird, so dass eine Wafer-Träger-Anordnung nach einem der Ansprüche 2 oder 3 bis 6 jeweils mit Rückbezug auf Anspruch 2 entsteht.

11. Verfahren nach Anspruch 9 oder 10, wobei als Schritt d) nach dem Schritt b) und gegebenenfalls nach dem Schritt c) eine Trennung zwischen dem Wafer (1) und der plasmapolymeren Trennschicht (4) erfolgt.

12. Verfahren nach Anspruch 10, wobei vor Schritt c) oder vor einer Trennung zwischen Wafer (1) und der Verbindungsmaterialschicht gegebenenfalls unter Veränderung der Verbindungsmaterialschicht der Wafer (1) vereinzelt wird und ggf. nach Schritt c) als Schritt d) eine Trennung zwischen dem Wafer (1) und der plasmapolymeren Trennschicht (4) erfolgt.

## Claims

1. A wafer/support arrangement, comprising:
- a wafer (1),
- a support layer system (5, 6) and
- a separating layer (4) which is arranged between the support layer system (5, 6) and the wafer (1),
wherein the support layer system (5, 6)
comprises
(i) a support layer (6) and
(ii) a layer (5) of a cured, partially cured or curable elastomer material on the separating-layer side, or consists of these two layers, and
wherein the separating layer (4)
(iii) is a plasma polymer layer and
(iv) the adhesive bond between the support layer system (5, 6) and the separating layer (4) once the elastomer material has cured is greater than the adhesive bond between the wafer (1) and the separating layer (4).

2. A wafer/support arrangement according to Claim 1, comprising on the side of the wafer which is remote from the separating layer (4) a connecting-material layer and a second support layer (17).

3. A wafer/support arrangement according to one of Claims 1 or 2, wherein the elastomer material in the partially cured state has a Shore A hardness which is at least 10% lower than in the cured state, and/or in the cured state has a Shore A hardness of 15 to 78.

4. A wafer/support arrangement according to one of Claims 1, 2 or 3, wherein the elastomer material is produced on a silicone basis.

5. A wafer/support arrangement according to one of Claims 1 to 4, wherein the support layer (6) is a polyimide layer or polyamide layer, a glass layer or a silicon layer.

6. A wafer/support arrangement according to one of Claims 1 to 5, wherein the coefficient of thermal expansion for the linear expansion of the support layer (6) deviates by at most 10x10⁻⁶/°C from that of the wafer (1).

7. Use of a wafer/support arrangement according to one of Claims 1 to 6 in the processing of the rear side of a wafer (1), preferably in the thinning and/or individualising of a wafer (1).

8. A method for producing a wafer/support arrangement according to one of Claims 1 or 3 to 6, comprising the steps:
a) providing a wafer (1),
b) providing a layer system, comprising a support layer (6) and a layer (5) of a cured, partially cured or curable elastomer material,
c) depositing a plasma polymer separating layer (4) on the wafer (1) or on the layer (5) of elastomer material, so that the adhesive bond between the support layer system (5, 6) and the separating layer (4) after joining of the support layer system (5, 6) with the wafer (1), wherein the joining is mediated by the separating layer (4), and the curing of the elastomer material will be greater than the adhesive bond between the wafer (1) and the separating layer (4),
d) joining the layer system to the wafer which is optionally coated with a plasma polymer separating layer (4), and
e) curing the elastomer material.

9. A method for processing the rear side of a wafer (1), comprising the steps:
a) producing a wafer/support arrangement according to one of Claims 1 or 3 to 6, wherein the separating layer (4) is attached to the front side of the wafer (1), and
b) processing the rear side of the wafer (1).

10. A method according to Claim 9, wherein as step c), after step b), a connecting-material layer and a second support layer (17) is attached to the rear side of the wafer (1), so that a wafer/support arrangement according to one of Claims 2 or 3 to 6 in each case with dependency from Claim 2 is produced.

11. A method according to Claim 9 or 10, wherein as step d), after step b) and optionally after step c), a separation between the wafer (1) and the plasma polymer separating layer (4) takes place.

12. A method according to Claim 10, wherein, before step c) or before a separation between the wafer (1) and the connecting-material layer, optionally with an alteration of the connecting-material layer, the wafer (1) is individualised and optionally after step c) as step d) a separation between the wafer (1) and the plasma polymer separating layer (4) takes place.

## Revendications

1. Ensemble de support de tranche, comprenant
- une tranche (1),
- un système de couches de support (5, 6) et
- une couche de séparation (4), qui est disposée entre le système de couches de support (5, 6) et la tranche (1),
sachant que le système de couches de support (5, 6) comprend
(i) une couche de support (6) et
(ii) une couche (5) constituée d'un matériau en élastomère durci, durci partiellement ou durcissable, côté couche de séparation, ou est constitué desdites deux couches, et
sachant que la couche de séparation (4)
(iii) est une couche en polymère plasma et
(iv) que le pouvoir d'adhérence entre le système de couches de support (5, 6) et la couche de séparation (4) est plus grand, après le durcissement du matériau en élastomère, que le pouvoir d'adhérence entre la tranche (1) et la couche de séparation (4).

2. Ensemble de support de tranche selon la revendication 1, comprenant, sur le côté, opposé à la couche de séparation (4), de la tranche, une couche de matériau de liaison et une deuxième couche de support (17).

3. Ensemble de support de tranche selon l'une quelconque des revendications 1 ou 2, dans lequel le matériau en élastomère présente, dans l'état partiellement durci, une dureté Shore A inférieure d'au moins 10 % que dans l'état durci, et/ou il présente, dans l'état durci, une dureté Shore A allant de 15 à 78.

4. Ensemble de support de tranche selon l'une quelconque des revendications 1, 2 ou 3, dans lequel le matériau en élastomère est fabriqué à base de silicone.

5. Ensemble de support de tranche selon l'une quelconque des revendications 1 à 4, dans lequel la couche de support (6) est une couche de polyimide ou de polyamide, une couche de verre ou une couche de silicium.

6. Ensemble de support de tranche selon l'une quelconque des revendications 1 à 5, dans lequel le coefficient de dilatation thermique pour la dilatation en longueur de la couche de support (6) diffère de celui de la tranche (1) au maximum de 10 * 10⁻⁶ /° C.

7. Utilisation d'un ensemble de support de tranche selon l'une quelconque des revendications 1 à 6 lors de l'usinage du côté arrière d'une tranche (1), de préférence lors de l'amincissement et/ou de l'isolation d'une tranche (1).

8. Procédé de fabrication d'un ensemble de support de tranche selon l'une quelconque des revendications 1 ou 3 à 6, comprenant les étapes suivantes consistant à :
a) fournir une tranche (1) ;
b) fournir un système de couches, comprenant une couche de support (6) et une couche (5) constituée d'un matériau en élastomère durci, partiellement durci ou durcissable ;
c) déposer une couche de séparation (4) en polymère plasma sur la tranche (1) ou sur la couche (5) constituée d'un matériau en élastomère de sorte que le pouvoir d'adhérence entre le système de couches de support (5, 6) et la couche de séparation (4) est plus important après la liaison du système de couches de support (5, 6) à la tranche (1), sachant que la liaison est mise en oeuvre par l'intermédiaire de la couche de séparation (4), et après le durcissement du matériau en élastomère que le pouvoir d'adhérence entre la tranche (1) et la couche de séparation (4) ;
d) relier le système de couches à la tranche recouverte éventuellement d'une couche de séparation (4) en polymère plasma ; et
e) faire durcir le matériau en élastomère.

9. Procédé servant à usiner le côté arrière d'une tranche (1), comprenant les étapes suivantes consistant à :
a) fabriquer un ensemble de support de tranche selon l'une quelconque des revendications 1 ou 3 à 6, sachant que la couche de séparation (4) est installée au niveau du côté avant de la tranche (1) ; et
b) usiner le côté arrière de la tranche (1).

10. Procédé selon la revendication 9, sachant qu'on applique, en tant qu'étape c), après l'étape b), sur le côté arrière de la tranche (1), une couche de matériau de liaison et une deuxième couche de support (17) de manière à obtenir un ensemble de support de tranche selon l'une quelconque des revendications 2 ou 3 à 6 respectivement avec un renvoi à la revendication 2.

11. Procédé selon la revendication 9 ou 10, dans lequel on effectue en tant qu'étape d), après l'étape b), et éventuellement après l'étape c), une séparation entre la tranche (1) et la couche de séparation (4) en polymère plasma.

12. Procédé selon la revendication 10, dans lequel la tranche (1) est isolée avant l'étape c) ou avant une séparation entre la tranche (1) et la couche de matériau de liaison éventuellement en modifiant la couche de matériau de liaison, et une séparation entre la tranche (1) et la couche de séparation (4) en polymère plasma est effectuée éventuellement après l'étape c) en tant qu'étape d).
